# EUROPEAN PATENT APPLICATION

(11) **EP 4 663 679 A1**
(43) Date of publication of application: **17.12.2025**
(21) Application number: 25181634.4
(22) Date of filing: 10.06.2025
(51) Int. Cl.: C08G 59/40, C09D 163/00, H01L 23/29

(54) **THERMOSETTING RESIN COMPOSITION AND USE THEREOF**

(30) Priority: 13.06.2024 JP 2024095762
(71) Applicant: Shin-Etsu Chemical Co., Ltd., Tokyo 100-0005 (JP)
(72) Inventor: Mochizuki, Takanari, Gunma, 3790224 (JP); Horigome, Hiroki, Gunma, 3790224 (JP); Osada, Shoichi, Gunma, 3790244 (JP)
(74) Representative: Angerhausen, Christoph

(57) **Abstract**

A thermosetting resin composition contains (A) an aliphatic bismaleimide compound represented by formula (1): 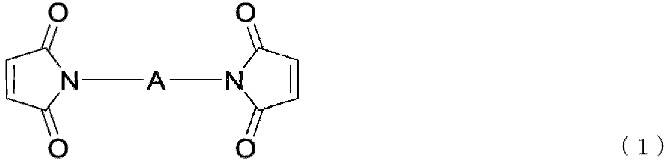 where in formula (1), A is a divalent aliphatic hydrocarbon group having 5 to 12 carbon atoms, and (B) an epoxy resin containing two or more epoxy groups in one molecule. The amount of component (A) is in the range of 20% to 95% by mass based on the total of component (A) and component (B).

## Description

### BACKGROUND OF THE INVENTION

### Field of the invention

The present invention relates to a cured product of a thermosetting resin suitable for use as an encapsulant for power semiconductors, and to use thereof.

### Background art

SiC power semiconductors have attracted much attention because they enable efficient power utilization and miniaturization of devices compared to Si power semiconductors in the related art. In recent years, there has been a noticeable trend toward further miniaturization and higher current handling in devices. Along with this trend, there is a strong demand for the development of an encapsulant material with high heat resistance and excellent tracking resistance, as indicated by a high comparative tracking index (CTI).

With regard to high heat resistance, JP-A-2015-193628 and JP-A-2019-064926 each report that a resin composition containing a maleimide-based resin has a glass transition temperature (Tg) higher than 300°C and a 5% weight loss temperature (Td5) higher than 400°C. This is presumably due to the high crosslink density that is characteristic of the maleimide-based resin, in addition to the rigidity of the aromatic ring component in the structure of each resin.

With regard to the tracking resistance, JP-A-2005-213299 and JP-A-2023-019588 each report that excellent tracking resistance can be achieved by introducing an alicyclic structure into an epoxy resin structure. This is presumably because the formation of carbonized conductive paths, which are the cause of tracking, is inhibited by reducing the proportion of aromatic rings in the structure.

### SUMMARY OF THE INVENTION

However, the resin compositions containing maleimide-based resins and having high heat resistance have poor tracking resistance, and the epoxy resin-containing resin compositions with tracking resistance have poor heat resistance.

It is therefore an object of the present invention to provide a thermosetting resin composition that gives a cured product with high heat resistance and excellent tracking resistance, and to provide an encapsulant for a semiconductor produced using the thermosetting resin composition.

The inventors have conducted intensive studies to achieve the above object and have found that the thermosetting resin composition as set forth below can achieve the above object, thereby completing the present invention.
<1> A thermosetting resin composition, comprising:
   (A) an aliphatic bismaleimide compound represented by formula (1): 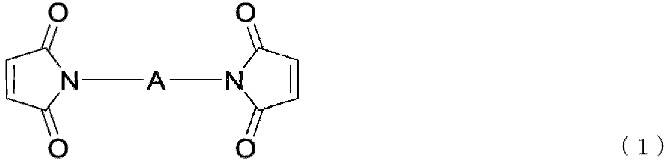 wherein, in formula (1), A is a divalent aliphatic hydrocarbon group having 5 to 12 carbon atoms; and
   (B) an epoxy resin containing two or more epoxy groups in one molecule, wherein the aliphatic bismaleimide compound (A) is in an amount of 20% to 95% by mass based on the total mass of the components (A) and (B).
<2> The thermosetting resin composition according to <1>, wherein in formula (1), A is a divalent chain aliphatic hydrocarbon group having 5 to 12 carbon atoms.
<3> The thermosetting resin composition according to <1> or <2>, further comprising (C) a curing accelerator.
<4> The thermosetting resin composition according to <3>, wherein the curing accelerator (C) contains one or more selected from imidazole-based curing accelerators, organophosphorus-based curing accelerators, and tertiary amine-based curing accelerators.
<5> An encapsulant for a semiconductor, comprising the thermosetting resin composition according to any one of <1> to <4>.
<6> The encapsulant for a semiconductor according to <5>, wherein the semiconductor is a power semiconductor.

The thermosetting resin composition as set forth in the above may provide a cured product with high glass transition temperature (Tg), high heat resistance, and excellent tracking resistance. Accordingly, the thermosetting resin composition as set forth above is useful for providing an encapsulant for a semiconductor, particularly for a power semiconductor, which is required to have high heat resistance, and excellent tracking resistance.

### DETAILED DESCRIPTION OF THE INVENTION

### [(A) Aliphatic Bismaleimide Compound]

Component (A) used in an embodiment of the present invention is an aliphatic bismaleimide compound represented by formula (1).

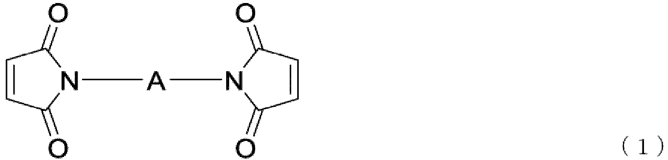

In formula (1), A is a divalent aliphatic hydrocarbon group having 5 to 12, preferably 6 to 9, carbon atoms. The aliphatic hydrocarbon group represented by A may be any of linear, branched, and cyclic. In particular, the aliphatic hydrocarbon group represented by A is preferably linear or branched.

The aliphatic bismaleimide compound of component (A) is not particularly limited in terms of its properties at room temperature (25°C ± 10°C) or its number-average molecular weight, but the number-average molecular weight is preferably 200 to 10,000, more preferably 200 to 5,000, and still more preferably 200 to 1,000.

In this specification, the number-average molecular weight refers to a number-average molecular weight calculated using polystyrene standards based on gel permeation chromatography (GPC) measurements conducted under the following measurement conditions.
GPC Measurement Conditions
Eluent: tetrahydrofuran (THF)
Flow rate: 0.35 mL/min
Detector: differential refractive index detector (RI)
Column: TSK Guardcolumn SuperH-L
   TSKgel SuperHZ4000 (4.6 mm I.D. × 15 cm × 1)
   TSKgel SuperHZ3000 (4.6 mm I.D. × 15 cm × 1)
   TSKgel SuperHZ2000 (4.6 mm I.D. × 15 cm × 2)
   (All manufactured by Tosoh Corporation)
Column temperature: 40°C
Sample injection volume: 5 µL (a THF solution with a concentration of 0.2% by mass)

When group A in the aliphatic bismaleimide compound of component (A) has less than 5 carbon atoms, the melting point of component (A) alone is about 200°C. This melting point overlaps with the temperature range in which the curing reaction proceeds, making it difficult to form a uniform cured product. For this reason, the number of carbon atoms in group A in the aliphatic bismaleimide compound of component (A) is required to be 5 or more, from the viewpoint of moldability of the composition. From the viewpoint of synthesis and availability of a diamine compound serving as a raw material of component (A), the upper limit of the number of carbon atoms in group A is 12.
As described above, the properties of the aliphatic bismaleimide compound of component (A) at room temperature are not particularly limited. The melting point of the aliphatic bismaleimide compound of component (A) is preferably lower than 160°C, more preferably lower than 140°C.

The aliphatic bismaleimide compound of component (A) may be used alone, or two or more types thereof may be used in combination.

The composition according to an embodiment of the present invention is characterized in that the amount of component (A) based on 100% by mass of the total amount of component (A) and component (B) is in the range of 20% to 95% by mass, preferably 50% to 95% by mass. When the amount of component (A) to component (B) is within this range, a cured product free of cracks is easily formed.

In the composition according to an embodiment of the present invention, the total amount of component (A) and component (B) is preferably in the range of 0.50% to 91% by mass, more preferably 0.99% to 76% by mass.

### [(B) Epoxy Resin]

The epoxy resin (B) is added for the purpose of promoting the reaction of the aliphatic bismaleimide compound (A) and for the purpose of maintaining the shape of the cured product.

The epoxy resin contains two or more epoxy groups in one molecule, and such a known epoxy resin can be used.

Examples thereof include bisphenol-type epoxy resins, such as bisphenol A-type epoxy resins, bisphenol F-type epoxy resins, and bisphenol S-type epoxy resins; novolac-type epoxy resins, such as phenolic novolac-type epoxy resins, cresol novolac-type epoxy resins, bisphenol A novolac-type epoxy resins, and bisphenol F novolac-type epoxy resins; alicyclic epoxy resins, such as dicyclopentadiene-type epoxy resins and 3,4-epoxycyclohexenylmethyl-3',4'-epoxycyclohexenecarboxylate; polyfunctional phenolic epoxy resins, such as resorcinol-type epoxy resins and resorcinol novolac-type epoxy resins; diglycidyl ether compounds of polycyclic aromatic compounds, such as stilbene-type epoxy resins, triazine skeleton-containing epoxy resins, fluorene skeleton-containing epoxy resins, triphenol alkane-type epoxy resins, biphenyl-type epoxy resins, xylylene-type epoxy resins, biphenyl aralkyl-type epoxy resins, naphthalene-type epoxy resins, and anthracene; and phosphorus-containing epoxy resins obtained by introducing phosphorus compounds into these resins.

Among these, epoxy resins containing cyclic saturated hydrocarbon groups in their molecules are preferably used because of their superior tracking resistance.

These may be used alone or in combination of two or more.

### [(C) Curing Accelerator]

The curing accelerator of component (C) is an optional component that is incorporated in order to accelerate the curing of the aliphatic bismaleimide compound (A). Commonly known curing accelerators, such as imidazole-based curing accelerators, organophosphorus-based curing accelerators, and tertiary amine-based curing accelerators, can be used.

Examples of the organophosphorus-based curing accelerator include phosphines, such as triphenylphosphine, tributylphosphine, tri(p-methylphenyl)phosphine, and tri(nonylphenyl)phosphine; phosphine-borane complexes, such as triphenylphosphine-triphenylborane; phosphonium borate salts, such as tetraphenylphosphonium tetraphenylborate, tetraphenylphosphonium tetra-p-tolylborate, p-tolyltriphenylphosphonium tetra-p-tolylborate, and tri-tert-butylphosphonium tetraphenylborate; and bis(tetrabutylphosphonium) dihydrogen pyromellitate.

Examples of the tertiary amine-based curing accelerator include tertiary amine compounds, such as triethylamine, benzyldimethylamine, α-methylbenzyldimethylamine, and 1,8-diazabicyclo[5.4.0]undec-7-ene; and salts of tertiary amine compounds, such as 1,8-diazabicyclo[5.4.0]undec-7-ene.

Examples of the imidazole-based curing accelerator include 2-methylimidazole, 2-phenylimidazole, 2-ethyl-4-methylimidazole, and 2-phenyl-4-methylimidazole.
Component (C) may be used alone, or two or more types thereof may be used in combination.

To promote curing, the amount of curing accelerator (C) added is preferably 0.01 to 10 parts by mass, more preferably 1 to 5 parts by mass, based on 100 parts by mass of the total of component (A) and component (B).

### [Other Additives]

In addition to components (A) to (C) described above, other additives may be added to the thermosetting resin composition according to an embodiment of the present invention, if necessary, within the range that does not impair the object and effects of the present invention. Examples of such additives include inorganic fillers, flame retardants, ion-trapping agents, antioxidants, adhesion-imparting agents, stress-reducing agents, and colorants.

Such an inorganic filler is incorporated into the thermosetting resin composition for the purposes of improving resin strength and reducing thermal expansion. Examples of the inorganic filler include silicas, such as fused silica, crystalline silica, and cristobalite, alumina, silicon nitride, aluminum nitride, boron nitride, titanium oxide, glass fibers, and magnesium oxide. The average particle diameters and shapes of these inorganic fillers can be selected in accordance with applications.

To increase the bonding strength between the resin and the inorganic filler, it is preferable to use an inorganic filler that has been subjected, in advance, to surface treatment with a coupling agent, such as a silane coupling agent or a titanate coupling agent.

Examples of the coupling agent include silane coupling agents, such as epoxysilanes, e.g., γ-glycidoxypropyltrimethoxysilane, γ-glycidoxypropylmethyldiethoxysilane, and β-(3,4-epoxycyclohexyl)ethyltrimethoxysilane; aminosilanes, e.g., N-β-(aminoethyl)-γ-aminopropyltrimethoxysilane, a reaction product of imidazole and γ-glycidoxypropyltrimethoxysilane, γ-aminopropyltriethoxysilane, and N-phenyl-γ-aminopropyltrimethoxysilane; and mercaptosilanes, e.g., γ-mercaptosilane and γ-episulfidoxypropyltrimethoxysilane. The amount of the coupling agent used in the surface treatment and a surface treatment method are not particularly limited.

The amount of the inorganic filler added is preferably 10 to 20,000 parts by mass, more preferably 30 to 10,000 parts by mass, based on 100 parts by mass of the total of component (A) and component (B).

The flame retardant is added for the purpose of imparting flame retardancy. The flame retardant is not particularly limited and any known flame retardant can be used. Examples of the flame retardant that can be used include phosphazene compounds, silicone compounds, zinc molybdate-supported talc, zinc molybdate-supported zinc oxide, aluminum hydroxide, magnesium hydroxide, and molybdenum oxide.

The ion-trapping agent is added for the purpose of trapping ionic impurities contained in the resin composition to inhibit thermal degradation and degradation due to moisture absorption. The ion-trapping agent is not particularly limited, and any known agent can be used. For example, a hydrotalcite, a bismuth hydroxide compound, or a rare-earth oxide may be used.

The antioxidant is not particularly limited. Examples thereof include phenolic antioxidants, such as n-octadecyl 3-(3,5-di-tert-butyl-4-hydroxyphenyl)propionate, n-octadecyl 3-(3,5-di-tert-butyl-4-hydroxyphenyl)acetate, neododecyl 3-(3,5-di-tert-butyl-4-hydroxyphenyl)propionate, dodecyl β-(3,5-di-tert-butyl-4-hydroxyphenyl)propionate, ethy α-(4-hydroxy-3,5-di-tert-butylphenyl)isobutyrate, octadecyl α-(4-hydroxy-3,5-di-tert-butylphenyl)isobutyrate, octadecyl α-(4-hydroxy-3,5-di-tert-butyl-4-hydroxyphenyl)propionate, 2-(n-octylthio)ethyl 3,5-di-tert-butyl-4-hydroxyphenylacetate, 2-(n-octadecylthio)ethyl 3,5-di-tert-butyl-4-hydroxyphenylacetate, 2-(n-octadecylthio)ethyl 3-(3,5-di-tert-butyl-4-hydroxyphenyl)propionate, 2-(2-stearoyloxyethylthio)ethyl 7-(3-methyl-5-tert-butyl-4-hydroxyphenyl)heptanoate, 2-hydroxyethyl 7-(3-methyl-5-tert-butyl-4-hydroxyphenyl)propionate, and pentaerythritol tetrakis[3-(3,5-di-tert-butyl-4-hydroxyphenyl)propionate]; sulfur antioxidants, such as dilauryl 3,3'-thiodipropionate, dimyristoyl 3,3'-thiodipropionate, distearyl 3,3'-thiodipropionate, ditridecyl 3,3'-thiodipropionate, and pentaerythrityl tetrakis(3-laurylthiopropionate); and phosphorus-based antioxidants, such as tridecyl phosphite, triphenyl phosphite, tris(2,4-di-tert-butylphenyl) phosphite, 2-ethylhexyl diphenyl phosphite, diphenyl tridecyl phosphite, 2,2-methylenebis(4,6-di-tert-butylphenyl) octyl phosphite, distearyl pentaerythritol diphosphite, bis(2,6-di-tert-butyl-4-methylphenyl) pentaerythritol diphosphite, and 2-[[2,4,8,10-tetrakis(1,1-dimethylethyl)dibenzo[d,fl[1,3,2] dioxaphosphepin-6-yl]oxy]-N,N-bis[2-[[2,4,8,10-tetrakis(1,1-dimethylethyl)dibenzo[d,f][1,3,2]dioxaphosphepin-6-yl]oxy]ethyl]ethanamine.

The adhesion-imparting agent is not particularly limited as long as it is a known adhesion-imparting agent and exhibits the effects of the present invention. An adhesion-imparting agent may be contained as necessary in order to impart adhesiveness or tackiness (pressure-sensitive adhesion). Examples of the adhesion-imparting agent include urethane resins, phenolic resins, terpene resins, and silane coupling agents. Among these, silane coupling agents are preferred for imparting adhesiveness.

The silane coupling agent is not particularly limited. Examples thereof include silane coupling agents, such as n-propyltrimethoxysilane, n-propyltriethoxysilane, n-octyltrimethoxysilane, n-octyltriethoxysilane, phenyltrimethoxysilane, phenyltriethoxysilane, methyltrimethoxysilane, methyltriethoxysilane, 2-[methoxy(polyethyleneoxy)propyl]trimethoxysilane, methoxytri(ethyleneoxy)propyltrimethoxysilane, 3-glycidyloxypropyltrimethoxysilane, 3-aminopropyltrimethoxysilane, 3-mercaptopropyltrimethoxysilane, 3-(methacryloyloxy)propyltrimethoxysilane, 3-isocyanatopropyltriethoxysilane, and 3-isocyanatopropyltrimethoxysilane.

The amount of the other additives added varies in accordance with the purpose of the composition, but is usually 5% or less by mass of the entire composition excluding the inorganic filler.

### [Method for Producing Composition]

The thermosetting resin composition according to an embodiment of the present invention can be produced by the following method. For example, components (A) and (B) are mixed, stirred, and dissolved and/or dispersed, either simultaneously or separately, if necessary, while being subjected to heat treatment, to provide a mixture of components (A) and (B). If necessary, curing accelerator (C) may be added to the mixture of components (A) and (B), and the mixture may be stirred and dissolved and/or dispersed to provide a mixture of components (A) to (C). Depending on the intended use, at least one of an inorganic filler, a flame retardant, a polymerization initiator, and an ion-trapping agent may be added to the mixture of components (A) to (C), and the resulting mixture may be mixed. A single type of each component may be used, or two or more types may be used in combination.

Any device may be used for mixing, stirring, and dispersing in the method for producing the composition. Specifically, for example, a mortar and pestle machine equipped with a stirring and heating device, a two-roll mill, a three-roll mill, a ball mill, a planetary mixer, or a grinder, such as a Supermasscolloider, can be used. These devices may also be used in appropriate combination.

### [Applications]

The thermosetting resin composition according to an embodiment of the present invention provides a cured product having excellent tracking resistance (CTI ≥ 600 V) and high heat resistance, and thus can be suitably used as an adhesive or an encapsulant for semiconductors.

When the thermosetting resin composition is used as an encapsulant for semiconductors, the components are preferably mixed together in a predetermined composition ratio as described above and sufficiently uniformly stirred with a mixer or the like. The mixture is preferably melt-mixed with a hot roll, a kneader, an extruder, or the like and then cooled to solidify the resulting product. The product is preferably pulverized to an appropriate size.

Examples of common molding methods using an encapsulant for semiconductors include a transfer molding method and a compression molding method. In the transfer molding method, a transfer molding machine is used. The method is performed at a molding pressure of 5 to 20 N/mm² and a molding temperature of 120°C to 190°C for a molding time of 30 to 500 seconds, preferably at a molding temperature of 150°C to 185°C for a molding time of 30 to 180 seconds. In the compression molding method, a compression molding machine is used. The method is performed at a molding temperature of 120°C to 190°C for a molding time of 30 to 600 seconds, preferably at a molding temperature of 130°C to 160°C for a molding time of 120 to 300 seconds. In either molding method, post curing may be performed at 150°C to 225°C for 0.5 to 20 hours.

### WORKING EXAMPLES

The present invention will be specifically described below with reference to working examples and comparative examples, but the present invention is not limited to the following working examples. In the following, the number-average molecular weight (Mn) was measured by gel permeation chromatography (GPC) under the following measurement conditions using polystyrene as a reference. In the following formulae, each Me represents a methyl group.
[GPC Measurement Conditions]
Eluent: tetrahydrofuran (THF)
Flow rate: 0.35 mL/min
Detector: differential refractive index detector (RI)
Column: TSK Guardcolumn SuperH-L
   TSKgel SuperHZ4000 (4.6 mm I.D. × 15 cm × 1)
   TSKgel SuperHZ3000 (4.6 mm I.D. × 15 cm × 1)
   TSKgel SuperHZ2000 (4.6 mm I.D. × 15 cm × 2)
   (All manufactured by Tosoh Corporation)
Column temperature: 40°C
Sample injection volume: 5 µL (THF solution with a concentration of 0.2% by mass)

### (A) Aliphatic Bismaleimide Compound

### [Synthesis Example 1]

First, 232.42 g (2.0 mol) of hexamethylenediamine, 411.85 g (4.2 mol) of maleic anhydride, 1,200 g of toluene, and 514 g of N-methyl-2-pyrrolidone were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize an amic acid. Thereafter, 192.20 g of methanesulfonic acid was added to the reaction liquid. The temperature was increased to 110°C. The mixture was stirred for 16 hours while removing by-produced water. The reaction liquid was washed five times with 500 g of ion-exchanged water. Afterward, heptane was used to induce precipitation, followed by filtration to give 357.92 g (yield: 65%) of a target product (A-1, Mn: 253, melting point: 143°C) as a white solid at room temperature.

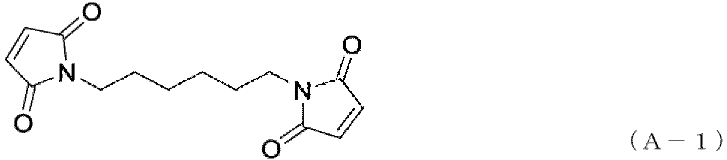

### [Synthesis Example 2]

First, 158.35 g (1.0 mol) of trimethylhexanediamine (mixture of 2,2,4- and 2,4,4-isomers), 205.94 g (2.1 mol) of maleic anhydride, 600 g of toluene, and 257 g of N-methyl-2-pyrrolidone were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize an amic acid. Thereafter, 96.10 g of methanesulfonic acid was added to the reaction liquid. The temperature was increased to 110°C. The mixture was stirred for 16 hours while removing by-produced water. The reaction liquid was washed five times with 300 g of ion-exchanged water. Afterward, heptane was used to induce precipitation, followed by filtration to give 237.81 g (yield: 75%) of a target product (A-2, Mn: 318, melting point: 88°C) as a white solid at room temperature.

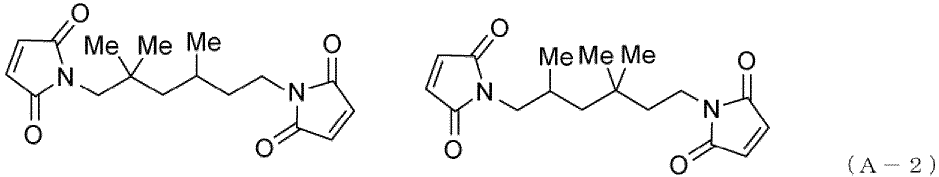

### [Synthesis Example 3]

First, 316.56 g (2.0 mol) of 1,9-nonanediamine, 411.96 g (4.2 mol) of maleic anhydride, 1,200 g of toluene, and 514 g of N-methyl-2-pyrrolidone were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize amic acid. Thereafter, 192.22 g of methanesulfonic acid was added to the reaction liquid. The temperature was increased to 110°C. The mixture was stirred for 16 hours while removing by-produced water. The reaction liquid was washed five times with 500 g of ion-exchanged water. Afterward, heptane was used to induce precipitation, followed by filtration to give 452.09 g (yield: 71%) of a target product (A-3, Mn: 346, melting point: 86°C) as a brown solid at room temperature.

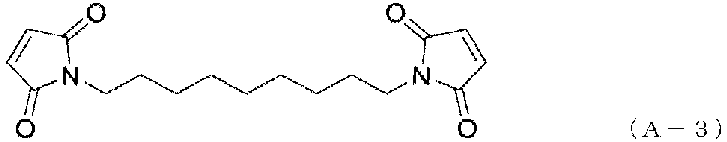

### [Synthesis Example 4]

First, 340.64 g (2.0 mol) of isophoronediamine (mixture of cis- and trans-isomers), 411.96 g (4.2 mol) of maleic anhydride, 870 g of toluene, and 870 g of N-methyl-2-pyrrolidone were placed in a 2-L four-necked glass flask equipped with a stirrer, a Dean-Stark tube, a cooling condenser, and a thermometer to prepare a reaction liquid. The reaction liquid was stirred at 80°C for 3 hours to synthesize an amic acid. Thereafter, 192.22 g of methanesulfonic acid was added to the reaction liquid. The temperature was increased to 110°C. The mixture was stirred for 16 hours while removing by-produced water. The reaction liquid was washed five times with 500 g of ion-exchanged water. Afterward, heptane was used to induce precipitation, followed by filtration to give 350.48 g (yield: 53%) of a target product (A-4, Mn: 295, melting point: 161°C) as a white solid at room temperature.

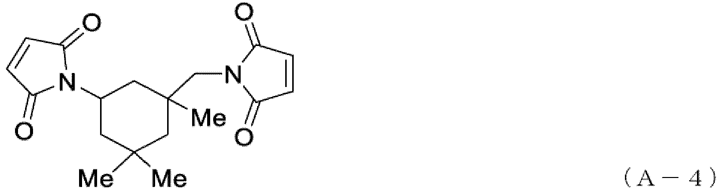

### [Comparative Synthesis Example 1]

First, 176.67 g (2.0 mol) of 1,4-butanediamine, 411.85 g (4.2 mol) of maleic anhydride, 870 g of toluene, and 870 g of N-methyl-2-pyrrolidone were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize amic acid. Thereafter, 192.25 g of methanesulfonic acid was added to the reaction liquid. The temperature was increased to 110°C. The mixture was stirred for 16 hours while removing by-produced water. The reaction liquid was washed five times with 500 g of ion-exchanged water. Afterward, heptane was used to induce precipitation, followed by filtration to give 348.84 g (yield: 70%) of a target product (A'-1, Mn: 205, melting point: 202°C) as a white solid at room temperature. 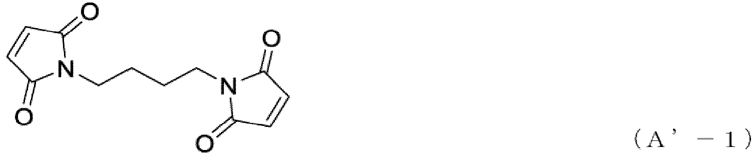 (A'-2) A maleimide compound represented by the following formula (SLK-6895: manufactured by Shin-Etsu Chemical Co., Ltd., liquid at room temperature)

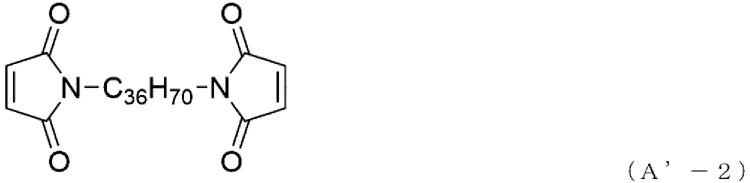

In the above formula, -C₃₆H₇₀- represents a hydrocarbon group having 36 carbon atoms, derived from a dimer acid.

### (B) Epoxy Resin

(B-1) Biphenyl-type epoxy resin (YX-4000K: manufactured by Mitsubishi Chemical Corporation, melting point: 105°C, epoxy equivalent: 185)
(B-2) Bisphenol A-type epoxy resin (YL-6810: manufactured by Mitsubishi Chemical Corporation, melting point: 45°C, epoxy equivalent: 172)
(B-3) Dicyclopentadiene-type epoxy resin (HP-7200: manufactured by DIC Corporation, softening point: 57°C, epoxy equivalent: 259)

### (C) Curing Accelerator

### (C-1) 2-Ethyl-4-methylimidazole (trade name: 2E4MZ, manufactured by Shikoku Kasei Holdings Corporation)

### (D) Phenolic Resin for Comparative Examples

### (D-1) Novolac-type phenolic resin (trade name: TD-2131, manufactured by DIC Corporation, softening point: 78°C, hydroxyl equivalent: 110)

### [Examples 1 to 7 and Comparative Examples 1 to 4]

The above components were mixed in amounts (parts by mass) given in Table 1. The mixture was cast into a mold and cured stepwise at 180°C for 1 hour and then at 230°C for 2 hours to provide a thermosetting resin composition. The resulting resin compositions were evaluated as described below. The results are presented in Table 1. The bismaleimide compound (A'-1) presented in Comparative Example 1 in Table 1 has a melting point near the temperature range (about 200°C) where the curing reaction proceeds. For this reason, when the components for the composition in Comparative Example 1 were mixed, the melting and curing reaction of the bismaleimide compound (A'-1) proceeded simultaneously, thereby failing to provide a uniform cured product.

In Table 1, each bismaleimide compound of component (A) is abbreviated as a "BMI compound".

### <Measurement of Glass Transition Temperature (Tg)>

The above components were mixed in amounts (parts by mass) given in Table 1. The mixture was cast into a mold and cured stepwise at 180°C for 1 hour and then at 230°C for 2 hours to provide a test specimen measuring 10 mm × 4 mm × 35 mm (thickness). The storage modulus (MPa) of the test specimen in the range of 25°C to 400°C was measured with a DMA-800 manufactured by TA Instruments. The temperature of the peak maximum obtained from a graph plotting Tan δ values derived from the values of the obtained storage modulus and loss modulus was used as the glass transition temperature (Tg).

### <Measurement of 5% Weight Loss Temperature (Td5)>

The above components were mixed in amounts (parts by mass) given in Table 1. The mixture was cast into a mold and cured stepwise at 180°C for 1 hour and then at 230°C for 2 hours. The resulting cured product was crushed with a hammer to provide small test specimens. The weight loss of the small test specimen in the temperature range of 25°C to 500°C was measured with a Thermo plus EVO2 manufactured by Rigaku Corporation. The temperature at which a weight loss of 5% from the weight before the start of the measurement was observed in the small test specimen was defined as Td5.

### <Measurement of Tracking Resistance (CTI)>

The above components were mixed in amounts (parts by mass) given in Table 1. The mixture was cast into a mold and cured stepwise at 180°C for 1 hour and then at 230°C for 2 hours to provide a disk-shaped cured product having a thickness of 3 mm and a diameter of 50 mm. The cured product was used to measure the tracking resistance according to the method of JIS C 2134:2021 (IEC 60112). As a tracking resistance voltage, in an evaluation in which five cured products were measured (n = 5), the maximum voltage at which none of the cured products broke even when 50 or more drops of a 0.1% aqueous solution of ammonium chloride fell thereon was measured. The upper limit was 600 V.

### <Measurement of Flexural Strength>

The above components were mixed in amounts (parts by mass) given in Table 1. The mixture was cast into a mold and cured stepwise at 180°C for 1 hour and then at 230°C for 2 hours to provide a test specimen measuring 100 mm × 10 mm × 4 mm (thickness). The test specimen was subjected to a three-point flexural test with an AUTOGRAPH manufactured by Shimadzu Corporation in accordance with JIS K 6911:2006, and the flexural strength was calculated.

**Table 1**

| | Working Example 1 | Working Example 2 | Working Example 3 | Working Example 4 | Working Example 5 | Working Example 6 | Working Example 7 | Comparative Example 1 | Comparative Example 2 | Comparative Example 3 | Comparative Example 4 |
|---|---|---|---|---|---|---|---|---|---|---|---|
| (A-1) BMI compound | 95 | - | - | - | 75 | 50 | 20 | - | - | - | - |
| (A-2) BMI compound | - | 95 | - | - | - | - | - | - | - | - | - |
| (A-3) BMI compound | - | - | 95 | - | - | - | - | - | - | - | - |
| (A-4) BMI compound | - | - | - | 95 | - | - | - | - | - | - | - |
| (A'-1) BMI compound | - | - | - | - | - | - | - | 95 | - | - | - |
| (A'-2) SLK-6895 | - | - | - | - | - | - | - | - | - | - | 95 |
| (B-1) YX-4000K | - | - | - | - | - | - | - | - | 63 | - | - |
| (B-2) YL-6810 | - | - | - | - | - | - | - | - | - | 61 | - |
| (B-3) HP-7200 | 5 | 5 | 5 | 5 | 25 | 50 | 80 | 5 | - | - | 5 |
| (C-1) 2E4MZ | 2 | 2 | 2 | 2 | 2 | 2 | 2 | 2 | 2 | 2 | 2 |
| (D-1) TD-2131 | - | - | - | - | - | - | - | - | 37 | 39 | - |
| Tg (°C) | 380 | 350 | 320 | 270 | 343 | 324 | 260 | - | 147 | 129 | 70 |
| Td5 (°C) | 406 | 402 | 410 | 415 | 380 | 352 | 325 | - | 362 | 374 | 365 |
| CTI (V) | 600 | 600 | 600 | 600 | 600 | 600 | 550 | - | 200 | 200 | 600 |
| Flexural strength (MPa) | 38 | 39 | 24 | 25 | 64 | 46 | 52 | - | 73 | 37 | - |

The results in Table 1 indicated that the cured products of the resin compositions of Examples 1 to 7, in which the aliphatic bismaleimide compounds each had a divalent aliphatic hydrocarbon group having 5 to 12 carbon atoms between two maleimide groups, all had excellent tracking resistance and high heat resistance.

## Claims

1. A thermosetting resin composition, comprising:
(A) an aliphatic bismaleimide compound represented by formula (1): 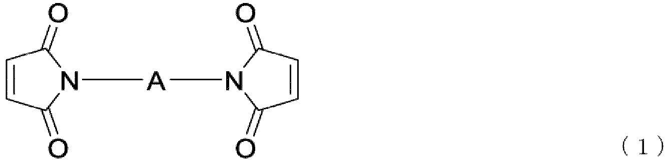 wherein, in formula (1), A is a divalent aliphatic hydrocarbon group having 5 to 12 carbon atoms; and
(B) an epoxy resin containing two or more epoxy groups in one molecule,
wherein the aliphatic bismaleimide compound (A) is in an amount of 20% to 95% by mass based on the total amount of the components (A) and (B).

2. The thermosetting resin composition according to claim 1, wherein in formula (1), A is a divalent chain aliphatic hydrocarbon group having 5 to 12 carbon atoms.

3. The thermosetting resin composition according to claim 1, further comprising (C) a curing accelerator.

4. The thermosetting resin composition according to claim 3, wherein the curing accelerator (C) contains one or more selected from imidazole-based curing accelerators, organophosphorus-based curing accelerators, and tertiary amine-based curing accelerators.

5. An encapsulant for a semiconductor, comprising the thermosetting resin composition according to any one of claims 1 to 4.

6. The encapsulant for a semiconductor according to claim 5, wherein the semiconductor is a power semiconductor.
